# DEMANDE DE BREVET EUROPEEN

(11) **EP 1 528 488 A1**
(43) Date de publication de la demande: **04.05.2005**
(21) Numéro de dépôt: 04356172.9
(22) Date de dépôt: 26.10.2004
(51) Int. Cl.: G06F 17/50

(54) **Atelier et procédé de conception d'un réseau prédiffusé programmable et support d'enregistrement pour leur mise en oeuvre**

(30) Priorité: 27.10.2003 FR 0312550
(71) Demandeur: Manoutsis, Patrice, 38570 Moretel de Mailles (FR); Seck, Amadou, 38400 Saint Martin D'Heres (FR); Bonnevial, Georges, 38400 Saint Martin d'Heres (FR)
(72) Inventeur: Manoutsis, Patrice, 38570 Moretel de Mailles (FR); Seck, Amadou, 38400 Saint Martin D'Heres (FR); Bonnevial, Georges, 38400 Saint Martin d'Heres (FR)
(74) Mandataire: Colombo, Michel

(57) **Abrégé**

Cet atelier de conception d'un réseau prédiffusé programmable (4), comporte :
- une portion de code prédéfinie (110), correspondant à un noyau temps réel câblé ce noyau temps réel câblé étant apte à synchroniser l'exécution de différents processeurs correspondant à des blocs fonctionnels définis par l'utilisateur lorsqu'il est implanté dans le réseau prédiffusé programmable, et
- un module (120) d'assemblage automatique par placement/routage de portions de code associées aux blocs fonctionnels définis par l'utilisateur et de la portion de code correspondant au noyau temps réel câblé de manière à obtenir un fichier (122) prêt à être téléchargé dans le réseau prédiffusé programmable.

## Description

L'invention concerne un atelier et un procédé de conception d'un réseau prédiffusé programmable ainsi qu'un support d'enregistrement pour leur mise en oeuvre.

Plus précisément, l'invention concerne un atelier comportant :
- une interface homme/machine et un module de création et de gestion d'une interface graphique permettant à un utilisateur de définir graphiquement des blocs fonctionnels et des relations entre ces blocs fonctionnels, chaque bloc fonctionnel étant associé à une portion de code respective correspondant chacune à au moins un processeur respectif à implanter dans le réseau prédiffusé programmable, ces différents processeurs à implanter étant destinés à s'exécuter en parallèle dans le réseau prédiffusé programmable, et
- des moyens de stockage d'informations propre à contenir lesdites portions de code.

Typiquement, les cartes électroniques d'aujourd'hui comportent un microprocesseur programmable cadencé par une horloge et associé à une mémoire comportant les instructions nécessaires à l'exécution d'une application. Ces microprocesseurs présentent l'avantage d'être utilisables pour un grand nombre d'applications différentes puisque les instructions peuvent être facilement modifiées.

Toutefois, ces microprocesseurs ne sont pas capables d'exécuter en parallèle plusieurs tâches. Au mieux, ils sont capables de simuler l'exécution en parallèle de plusieurs tâches en partageant, par exemple, le temps d'exécution entre les différentes tâches à exécuter.

Lorsque certaines tâches à exécuter doivent l'être plus rapidement que ce qui est possible avec un microprocesseur ou si plusieurs tâches doivent être exécutées en parallèle, un coprocesseur dédié à l'exécution de ces tâches est associé au microprocesseur.

Pour des raisons de rapidité, ces coprocesseurs sont souvent réalisés à partir de réseaux prédiffusés programmables, tels que, par exemple, des composants FPGA (Field Programmable Gate Array). Un réseau prédiffusé programmable se présente typiquement sous la forme d'un réseau formé dans un substrat semiconducteur. Les noeuds de ce réseau sont capables d'effectuer des opérations élémentaires telles que, par exemple, des opérations booléennes "ET", "OU", "NOR"...etc. Ces noeuds sont reliés entre eux par des liaisons et ces liaisons sont programmables. Ainsi, lors de la programmation d'un réseau prédiffusé, des liaisons entre les différents noeuds sont activées ou, au contraire, inhibées, de manière à ce qu'une tâche déterminée puisse être exécutée. Cette tâche étant câblée, elle s'exécute beaucoup plus rapidement que sur un microprocesseur. L'ensemble des noeuds reliés entre eux pour réaliser une tâche spécifique est ici appelé processeur. Typiquement, lors de la conception d'un réseau prédiffusé, plusieurs processeurs sont implantés les uns à côté des autres dans le même réseau, chacun de ces processeurs pouvant alors être exécuté en parallèle des autres. Souvent, également, plusieurs processeurs sont regroupés en un ensemble fonctionnel réalisant une fonction plus complexe, telle que, par exemple, une fonction de régulation et/ou d'asservissement d'un moteur en position ou autre.

Ces ensembles fonctionnels sont généralement indépendants les uns des autres et peuvent être exécutés de façon autonome.

Dès lors, on comprend que les réseaux prédiffusés présentent l'avantage d'être plus rapides pour exécuter certaines tâches ou fonctions spécifiques, telles que, par exemple, des tâches ou fonctions faisant principalement intervenir des opérations booléennes. De plus, ces réseaux prédiffusés sont capables de réaliser, en parallèle, plusieurs tâches ou plusieurs fonctions.

Jusqu'à présent, la conception d'un tel réseau prédiffusé était compliquée car elle supposait l'intervention d'un technicien spécialisé capable d'écrire de A à Z le code correspondant aux différents processeurs à implanter dans le réseau prédiffusé.

Par code, on désigne ici l'ensemble des instructions qui, par exemple après avoir été compilé, est destiné à être téléchargé dans le réseau prédiffusé programmable et détermine les liaisons du réseau à activer ou à inhiber. Ce code est typiquement écrit à l'aide d'un langage de programmation.

Pour résoudre ce problème, des sociétés ont proposé des ateliers de conception de réseaux prédiffusés programmables. Un tel atelier est, par exemple, l'atelier "LABVIEW" de NATIONAL INSTRUMENTS avec le module "LABVIEW FPGA MODULE".

Cet atelier comporte un ordinateur dans lequel est montée une carte électronique vendue par NATIONAL INSTRUMENTS. Cette carte électronique comporte un microprocesseur associé à un composant FPGA. L'atelier comporte une interface homme/machine permettant de définir graphiquement des blocs fonctionnels correspondant à des ensembles fonctionnels à implanter dans le composant FPGA. Une fois les différents blocs fonctionnels définis graphiquement, l'atelier génère un code correspondant et permet de télécharger ce code dans le composant FPGA. Cet atelier est donc particulièrement simple à utiliser puisqu'il est possible de concevoir des ensembles fonctionnels sans écrire de code.

Lors du fonctionnement de la carte électronique ainsi programmée, les ensembles fonctionnels sont exécutés indépendamment les uns des autres. La synchronisation de l'exécution de ces différents ensembles fonctionnels dans le composant FPGA, et notamment la synchronisation des accès à des ressources matérielles communes de la carte électronique, doit être gérée par un calculateur électronique externe au composant FPGA. Ces opérations de synchronisation requièrent une puissance de traitement qui reste importante et qui nécessite un calculateur puissant et donc cher.

Pour son atelier, NATIONAL INSTRUMENTS utilise comme calculateur de synchronisation, le calculateur de l'ordinateur qui est raccordé au composant FPGA par l'intermédiaire d'un bus d'interface et du microprocesseur embarqué sur la carte électronique.

Dès lors, les ateliers connus ne permettent pas la conception de composants FPGA destinés à être incorporés dans des cartes électroniques autonomes équipées de microprocesseurs à faible coût.

L'invention vise à remédier à cet inconvénient en proposant un atelier de conception de réseaux prédiffusés programmables présentant la simplicité des ateliers connus tout en permettant la conception de réseaux prédiffusés programmables aptes à équiper des cartes électroniques autonomes et peu coûteuses.

L'invention a donc pour objet un atelier de conception tel que décrit ci-dessus, caractérisé :
- en ce que les moyens de stockage d'informations comportent une portion de code prédéfinie correspondant à un noyau temps réel câblé, ce noyau temps réel câblé étant apte à synchroniser l'exécution des différents processeurs correspondant aux blocs fonctionnels définis par l'utilisateur lorsqu'il est implanté dans le réseau prédiffusé programmable, et
- en ce que l'atelier comporte un module d'assemblage automatique par placement/routage des portions de code associées aux blocs fonctionnels définis par l'utilisateur et de la portion de code correspondant au noyau temps réel câblé de manière à obtenir un fichier prêt à être téléchargé dans le réseau prédiffusé programmable.

Dans l'atelier ci-dessus, la synchronisation des différents processeurs correspondant aux blocs fonctionnels définis par l'utilisateur est réalisée par le noyau temps réel câblé implanté lui-même dans le réseau prédiffusé programmable.

Ainsi, un calculateur associé au réseau prédiffusé programmable ainsi conçu n'a pas besoin de s'occuper de toutes les tâches de synchronisation des différents processeurs exécutés en parallèle dans le réseau prédiffusé. Dès lors, à fonctionnalité égale par rapport à un réseau prédiffusé programmable conçu à l'aide d'un atelier connu, la puissance de traitement nécessaire pour le calculateur est réduite. Un calculateur moins puissant et donc moins coûteux peut être utilisé pour interagir avec le réseau prédiffusé.

Dès lors, il n'est plus nécessaire d'utiliser systématiquement le calculateur d'un ordinateur personnel. Au contraire, il devient possible de réaliser des cartes électroniques autonomes regroupant, par exemple, sur une même carte le calculateur et le composant FPGA sans que ces cartes aient un coût prohibitif.

De plus, l'utilisation de l'atelier ci-dessus reste simple puisque les blocs fonctionnels sont définis graphiquement par l'utilisateur sans que celui-ci n'ait à écrire de code, et en particulier, l'utilisateur n'a pas à écrire lui-même le code correspondant au noyau temps réel câblé puisque celui-ci est déjà prédéfini.

Suivant d'autres caractéristiques de l'atelier conforme à l'invention, celui-ci se caractérise en ce que :
- l'interface homme / machine et le module de création et de gestion de l'interface graphique sont aptes à permettre la sélection par l'utilisateur d'au moins un bloc fonctionnel prédéfini, chaque bloc fonctionnel prédéfini étant associé à une portion de code prédéfinie correspondant à au moins un processeur prédéfini apte à coopérer avec le noyau temps réel câblé lorsqu'il est implanté dans le composant ;
- l'interface homme / machine et le module de création et de gestion de l'interface graphique sont aptes à permettre la sélection par l'utilisateur d'au moins un bloc fonctionnel prédéfini paramétrable, et la définition par l'utilisateur des valeurs du ou de chaque paramètre du bloc fonctionnel prédéfini paramétrable sélectionné, chaque bloc fonctionnel prédéfini paramétrable étant associé à une portion de code prédéfinie correspondant à au moins un processeur prédéfini paramétrable, chaque processeur paramétrable étant apte à émettre une requête de lecture de la valeur du ou de chaque paramètre nécessaire à son fonctionnement lors de son exécution dans le réseau prédiffusé programmable, et la portion de code prédéfinie correspondant au noyau temps réel câblé correspond à un noyau temps réel câblé apte, en réponse auxdites requêtes de lecture, à lire la valeur des paramètres correspondant dans un fichier enregistré dans une mémoire externe réinscriptible associée au réseau prédiffusé programmable, et à transmettre la valeur du ou de chaque paramètre lu au processeur l'ayant demandée ;
- il comporte un module de génération apte à produire automatiquement ledit fichier à partir de la définition des blocs fonctionnels sélectionnés par l'utilisateur ;
- l'interface homme / machine et le module de création et de gestion sont aptes à permettre la définition du fonctionnement d'un bloc fonctionnel non-prédéfini par écriture dans un langage de programmation de cette définition et à permettre à l'utilisateur de définir graphiquement des relations entre ce bloc fonctionnel non-prédéfini et d'autres blocs fonctionnels prédéfinis, et en ce qu'il comporte un compilateur propre à compiler la définition écrite avec le langage de programmation pour créer un code compilé associé à ce bloc fonctionnel non-prédéfini apte à être assemblé par le module d'assemblage avec la portion de code prédéfinie correspondant au noyau temps réel câblé ;
- les moyens de stockage d'informations contiennent une portion de code prédéfinie correspondant à un processeur prédéfini formant interface d'entrée, ce processeur étant apte, lorsqu'il est implanté dans le réseau prédiffusé programmable, à gérer les échanges d'informations entre un microprocesseur externe associé au réseau prédiffusé programmable et les différents processeurs correspondant aux blocs fonctionnels définis par l'utilisateur, et en ce que le module d'assemblage est apte à assembler automatiquement et systématiquement en plus des portions de code associées aux blocs fonctionnels définis par l'utilisateur et au noyau temps réel câblé, la portion de code prédéfinie de ce processeur formant interface d'entrée ;
- les moyens de stockage d'informations comportent une librairie prédéfinie de procédures aptes à être implémentées dans le microprocesseur associé au réseau prédiffusé programmable pour permettre à ce microprocesseur d'échanger des informations entre les différents processeurs implantés dans le réseau prédiffusé programmable par l'intermédiaire du processeur formant interface d'entrée ;
- les moyens de stockage d'informations contiennent une portion de code prédéfinie correspondant à un processeur prédéfini formant interface de sortie, ce processeur étant apte, lorsqu'il est implanté dans le réseau prédiffusé programmable, à gérer les échanges d'informations entre au moins un dispositif électronique commandable raccordé au réseau prédiffusé programmable et au moins l'un des processeurs implantés dans le réseau prédiffusé programmable, et le module d'assemblage est apte à assembler systématiquement et automatiquement, en plus des portions de code associées aux blocs fonctionnels définis par l'utilisateur et au noyau temps réel câblé, la portion de code prédéfinie de ce processeur formant interface de sortie ;
- la portion de code prédéfinie correspondant au processeur formant interface de sortie, correspond à un processeur formant interface de sortie apte à reconnaître automatiquement le ou chaque dispositif électronique commandable raccordé au réseau prédiffusé programmable pour communiquer avec celui-ci à l'aide d'un protocole approprié ;
- il comporte un module de téléchargement du fichier généré par le module d'assemblage dans le réseau prédiffusé programmable ;
- la portion de code correspondant au noyau temps réel câblé et / ou les portions de codes prédéfinies correspondant aux processeurs prédéfinis sont des portions de codes précompilées prêtes à être téléchargées dans le réseau prédiffusé programmable.

L'invention concerne également un procédé de conception d'un réseau prédiffusé programmable formé dans un substrat, ce procédé comportant :
- une étape de création et de gestion automatique d'une interface graphique permettant à un utilisateur de définir graphiquement des blocs fonctionnels et des relations entre ces blocs fonctionnels, chaque bloc fonctionnel étant associé à une portion de code respective correspondant à au moins un processeur à implanter dans le réseau prédiffusé programmable, ces différents processeurs à implanter étant destinés à s'exécuter en parallèle dans le réseau prédiffusé programmable, caractérisé en ce qu'il comporte :

- une étape d'assemblage automatique par placement / routage des différentes portions de code associées aux blocs fonctionnels définis par l'utilisateur et d'une portion de code prédéfinie correspondant à un noyau temps réel câblé de manière à obtenir un fichier prêt à être téléchargé dans le réseau prédiffusé programmable, la portion de code prédéfinie correspondant au noyau temps réel câblé étant apte à synchroniser l'exécution des différents processeurs associés aux blocs fonctionnels définis par l'utilisateur lorsqu'ils sont implantés dans le réseau prédiffusé programmable.

Suivant une autre caractéristique du procédé conforme à l'invention celui-ci se caractérise en ce qu'il comporte une étape de création et de gestion d'une interface graphique permettant la sélection par un utilisateur de blocs fonctionnels prédéfinis associés chacun à une portion de code prédéfinie correspondant à au moins un processeur prédéfini apte à coopérer avec le noyau temps réel câblé lorsqu'il est implanté dans le réseau prédiffusé programmable.

L'invention concerne également un support d'enregistrement d'informations, caractérisé en ce qu'il comporte des instructions pour l'exécution du procédé de conception et à la mise en oeuvre de l'atelier conforme à l'invention, lorsque ces instructions sont exécutées par un ordinateur.

L'invention sera mieux comprise à la lecture qui va suivre, donnée uniquement à titre d'exemple et faite en se référant aux dessins sur lesquels :
- la figure 1 est une illustration schématique d'un atelier conforme à l'invention, et
- la figure 2 est un organigramme d'un procédé de conception conforme à l'invention.

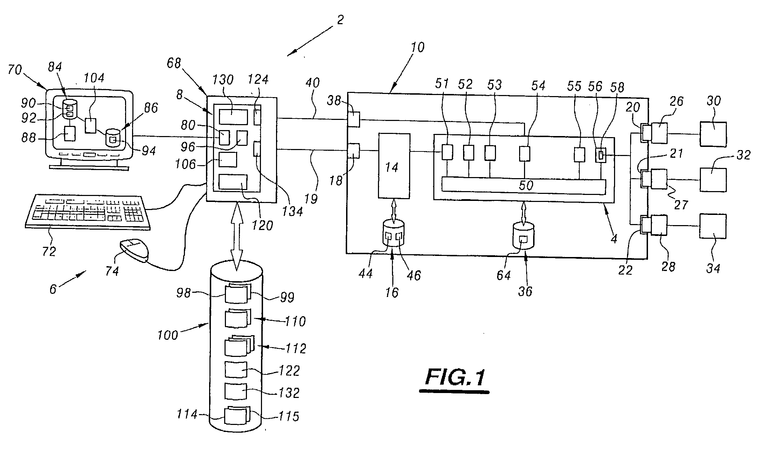

La figure 1 représente un atelier, désigné par la référence générale 2, de conception et de programmation d'un réseau prédiffusé programmable. L'atelier 2 sera décrit ici dans le cas particulier où le réseau prédiffusé programmable est un composant FPGA 4.

L'atelier 2 comporte un ordinateur 6 équipé d'un logiciel de conception 8 et associé à une carte électronique 10.

La carte électronique 10 est ici représentée, à titre d'illustration, à l'extérieur du châssis de l'ordinateur 6.

La carte électronique 10 comporte le composant 4 à programmer ainsi qu'un microprocesseur programmable 14.

Le microprocesseur 14 est associé à une mémoire RAM 16 (Random Access Memory) et à un connecteur 18 permettant de raccorder le microprocesseur à l'ordinateur 6, par exemple, par l'intermédiaire d'un bus USB 19 (Universal Serial Bus).

Le composant 4 est raccordé d'un côté au microprocesseur 14 et de l'autre côté à des connecteurs destinés à recevoir des cartes d'interfaces embrochables.

A titre d'illustration, le composant 4 est ici raccordé à trois connecteurs 20, 21 et 22 et trois cartes d'interfaces embrochables 26, 27 et 28 sont raccordées respectivement aux connecteurs 20, 21 et 22.

La carte 26 est ici raccordée à un moteur pas-à-pas 30. Cette carte 26 est donc destinée, ici, à transmettre des commandes issues du composant 4 vers ce moteur 30.

La carte 27 est apte à assurer l'interface entre le composant 4 et un capteur 32 de position de l'arbre du moteur 30 tandis que la carte 28 est apte à assurer l'interface entre le composant 4 et un clavier 34 d'entrée de consigne.

Le composant 4 est également associé sur la carte électronique 10 à une mémoire réinscriptible 36 et à un connecteur 38 permettant de raccorder des broches de programmation du composant 4 à l'ordinateur 6 par l'intermédiaire d'un bus JTAG 40 (Joint Test Action Group).

La mémoire 16 contient le programme destiné à être exécuté par le microprocesseur 14 et notamment deux librairies de procédures 44 et 46.

La librairie 44 comporte uniquement des procédures mises en oeuvre par le microprocesseur 14 pour échanger des informations avec le composant 4 et plus précisément avec les différents processeurs implantés dans ce composant.

La librairie 46 contient uniquement des procédures mises en oeuvre par le micro processeur 14 pour échanger des informations avec l'ordinateur 6 par l'intermédiaire du bus 19.

Ces librairies 44, 46 sont plus connues sous l'acronyme anglais API (Application Programming Interface).

Lorsque le composant 4 a été programmé à l'aide de l'atelier 2, celui-ci comporte un noyau temps réel câblé 50 et plusieurs processeurs aptes à s'exécuter en parallèle. Ici à titre d'illustration, seuls six processeurs 51 à 56 sont représentés.

Le noyau 50 est apte à synchroniser l'exécution en parallèle des différents processeurs implantés dans le composant 4 notamment lors de leur accès à des ressources matérielles communes de la carte 10 telles que, par exemple, la mémoire 36. Cette synchronisation ou gestion de l'accès aux ressources matérielles communes se fait, par exemple, en affectant à chaque processeur un niveau de priorité pour ce qui est de l'accès à cette ressource commune et en donnant toujours au processeur affecté du niveau de priorité le plus élevé, l'accès à la ressource commune.

Les processeurs 51 à 56 sont implantés chacun dans une zone différente du composant 4 et conçus chacun pour réaliser une tâche spécifique. Dès lors, ici le composant 4 est apte à exécuter en parallèle six tâches.

Le processeur 51, appelé par la suite interface d'entrée, est apte à gérer les échanges d'informations entre le microprocesseur 14 et les autres processeurs implantés dans le composant 4. En particulier, il est apte à enregistrer dans la mémoire 36 des informations transmises par le microprocesseur 14 et, à l'inverse, à lire des informations enregistrées dans la mémoire 36 pour les transmettre au microprocesseur 14.

Le processeur 56, appelé par la suite interface de sortie, est apte à gérer les échanges d'informations entre les différentes cartes d'interfaces 26 à 28 et les autres processeurs implantés dans le composant 4.

En particulier, le processeur 56 est apte à enregistrer dans la mémoire 36 les informations acquises par l'intermédiaire des cartes d'interface 26 à 28 et à lire des informations dans la mémoire 36 pour les transmettre à ces cartes d'interface.

De plus, ici, ce processeur 56 est apte à exécuter un module 58 de reconnaissance automatique des cartes d'interfaces raccordées aux connecteurs 20 à 22 de manière à déterminer automatiquement la nature et l'objet des informations transmises ou reçues par l'intermédiaire de ces cartes. Typiquement, chaque carte d'interface comporte un identificateur et le module de reconnaissance 58 est capable de lire cet identificateur afin, par exemple, de déterminer dans quelle zone de la mémoire 36 doivent être enregistrées les informations transmises par cette carte.

Les processeurs 52 à 55 sont aptes à réaliser les tâches spécifiques définies à l'aide du logiciel de conception 8.

Les processeurs 52 à 54 sont des processeurs prédéfinis paramétrés aptes à émettre des requêtes de lecture de la valeur des paramètres nécessaires à leur fonctionnement. Ces processeurs sont également aptes à émettre des requêtes d'accès à la mémoire 36 pour lire ou écrire des informations dans celle-ci. Quelles que soient les requêtes d'accès à la mémoire 36, celles-ci sont interceptées et traitées par le noyau 50.

A titre d'illustration, le processeur 55 est un processeur apte à acquérir les informations du capteur 32 et à les enregistrer dans la mémoire 36.

De plus, ici, le processeur 55 est conçu pour que lors de son initialisation, il émette une requête de lecture d'un paramètre dans la mémoire 36 définissant, par exemple, une mise à l'échelle des informations transmises par le capteur 32. Les valeurs des paramètres nécessaires à l'exécution des processeurs sont toutes contenues dans un fichier commun 64, appelé table de description, et stocké dans la mémoire 36.

Le processeur 54 est un processeur apte à filtrer les informations acquises et traitées par le processeur 55.

Le processeur 53 est un processeur apte à asservir en position l'arbre du moteur 30 en fonction d'une consigne de position et des informations filtrées par le processeur 54.

Le processeur 53 est conçu, par exemple, pour que lors de son initialisation, il émette automatiquement une requête de lecture de la valeur de deux paramètres contenus dans le fichier 64, la valeur de ces deux paramètres intervenant dans le fonctionnement de l'algorithme d'asservissement de la position du moteur 30.

Le processeur 52 est apte à acquérir une consigne de position saisie à l'aide du clavier 54 et à la transmettre au processeur 53.

L'ordinateur 8 est un ordinateur conventionnel équipé d'une unité centrale 68 et d'une interface homme / machine formée, à titre d'exemple, d'un écran 70, d'un clavier 72 et un dispositif de pointage tel qu'une souris 74.

L'unité centrale 68 est apte à exécuter le logiciel 8.

Le logiciel 8 comporte un module 80 de création et de gestion d'une interface graphique permettant à un utilisateur de définir graphiquement un projet de conception formé de blocs fonctionnels reliés entre eux. En particulier, le module 80 permet à l'utilisateur de sélectionner des blocs fonctionnels prédéfinis à insérer dans son projet parmi une bibliothèque de blocs fonctionnels prédéfinis.

Chaque bloc fonctionnel prédéfini est associé à une portion de code prédéfinie enregistrée dans une mémoire 100 associée à l'ordinateur 6.

Ces portions de codes correspondent chacune à un processeur ou à un ensemble de processeurs prêts à être implantés dans le composant 4.

Parmi ces blocs fonctionnels prédéfinis, certains sont dits paramétrables et sont associés à des portions de code 98 prédéfinies correspondant à des processeurs prédéfinis paramétrables.

Les processeurs paramétrables sont des processeurs dont le fonctionnement dépend de la valeur de certains paramètres enregistrés, ici, dans le fichier 64 contenu dans la mémoire 36. A cet effet ces processeurs prédéfinis paramétrables sont aptes à émettre une requête de lecture de la valeur de leurs paramètres respectifs lorsqu'ils sont exécutés dans le composant 4. Les blocs fonctionnels paramétrables permettent uniquement à l'utilisateur de modifier ou de définir la valeur des paramètres nécessaires au fonctionnement des processeurs correspondants.

Le module 80 permet également de sélectionner des blocs prédéfinis non-paramètrables par l'utilisateur associés à des portions de code prédéfinies 99 correspondant à des processeurs prédéfinis non-paramètrables.

De préférence, les portions de codes 98, 99 sont des portions de codes précompilées de manière à ce qu'aucune opération de compilation ne soit nécessaire pour implanter chacune de ces portions de code dans le composant 4. Ces portions de code 98, 99 ne peuvent par être modifiées par l'utilisateur. L'utilisateur ne peut spécifier par l'intermédiaire de l'interface homme / machine au mieux que la valeur des paramètres.

Par exemple, deux blocs fonctionnels prédéfinis paramétrables 84 et 86 sont représentés sur l'écran 70. Chacun de ces blocs fonctionnels est associé à l'une des portions de code prédéfinies 98 correspondant respectivement aux processeurs 53 et 55 lorsqu'ils sont implantés dans le composant 4. A cet effet, la représentation graphique de chaque bloc fonctionnel comporte un ou plusieurs éléments de commande adaptés pour être activés à l'aide de la souris 74 tels que, par exemple, des éléments de commandes 90 et 92 pour le bloc fonctionnel 84 et un élément de commande 94 pour le bloc fonctionnel 86. Lorsque l'un de ces éléments de commande est activé, il est propre à générer un signal de commande à destination du logiciel 8 et plus particulièrement d'un module de construction de la table de description pour indiquer pour quel paramètre et quel processeur prédéfini paramétrable l'utilisateur va saisir une valeur.

L'écran 70 comporte également un bloc fonctionnel 88 associé à l'une des portions de code prédéfinies 99 correspondant au processeur prédéfini non-paramètrable 52 lorsqu'il est implanté dans le composant 4.

Le module 80 permet également à l'utilisateur d'insérer graphiquement dans le projet un bloc fonctionnel non-prédéfini 104. Contrairement aux blocs fonctionnels prédéfinis, ce bloc fonctionnel 104 n'est associé à aucune portion de code prédéfinie dans la mémoire 100. Par contre, le module 80 permet à l'utilisateur d'écrire le code décrivant le fonctionnement de ce bloc fonctionnel dans un langage de programmation connu tel que le langage VHDL (Very High Speed Integrated Circuit Hardware Description Language) ou Verilog.

De manière à pouvoir transformer le code de ce bloc fonctionnel 104 en un code prêt à être implanté dans le composant 4, le logiciel 8 comporte un compilateur conventionnel 106.

A titre d'exemple, ici, pour le bloc 104 l'utilisateur a écrit un programme correspondant à un algorithme de filtrage des signaux transmis par le bloc 88 et le bloc 104 correspond au processeur 54 lorsqu'il est implanté dans le composant 4.

Le module 80 est également adapté pour que l'utilisateur puisse définir graphiquement des échanges d'informations entre les différents blocs qu'il a sélectionnés par de simples relations entre ces blocs. A titre d'exemple, ici une sortie du bloc 86 est reliée à une entrée du bloc 104 de manière à indiquer que la valeur acquise par le bloc 86 doit être transmise au bloc 104. Le bloc 104 est raccordé au bloc 84 pour indiquer que la valeur qu'il a filtré est transmise en tant que mesure de la position de l'arbre du moteur 30 au bloc 84. Le bloc 88 est quant à lui raccordé à une entrée du bloc 84 destinée à recevoir la consigne d'asservissement.

Dans l'atelier 2, la mémoire 100 contient également un noyau temps réel câblé enregistré sous la forme d'un code prédéfini et précompilé 110, des interfaces de programmation 112 et des portions de code prédéfinies 114, 115 correspondant respectivement aux processeurs 51 et 56 quand elles sont implantées dans le composant 4.

Le code 110 correspond au code du noyau 50 avant que celui-ci ne soit implanté dans le composant 4. Ce code ne peut pas être créé ou modifié par l'utilisateur de l'atelier 2.

Les interfaces de programmation 112 sont formées ici d'une interface de programmation destinée à être exécutée par l'ordinateur 6 pour lui permettre d'échanger des informations avec le microprocesseur 14 par l'intermédiaire du bus 19.

Les interfaces de programmation 112 comportent également l'ensemble des procédures destinées à être utilisées par le microprocesseur 14 pour communiquer d'une part avec l'ordinateur 6 par l'intermédiaire du bus 19 et d'autre part avec le composant 4 par l'intermédiaire du processeur 51, et ceci quels que soient les processeurs implantés dans le composant 4.

Les portions de code 114 et 115 sont précompilées.

Le logiciel 8 comporte un module 120 d'assemblage automatique des différentes portions de code précompilées ou compilées de manière à créer un fichier 122 destiné à être téléchargé par un module 124 dans le composant 4 par l'intermédiaire du bus 40.

Le logiciel 8 a également un module 130 de génération automatique d'une table de description 132 destinée à être téléchargée par un module 134 dans la mémoire 36 par l'intermédiaire du bus 19. Cette table de description est un fichier contenant l'ensemble des valeurs des paramètres des blocs fonctionnels paramétrables définis par l'utilisateur dans le projet de conception.

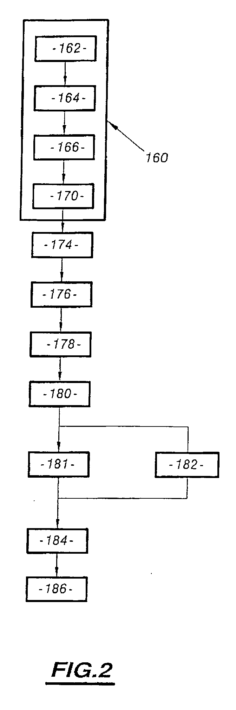

Le fonctionnement de l'atelier 2 va maintenant être décrit en regard du procédé de la figure 2.

Lors d'une étape 160, le module 80 crée et gère une interface graphique sur l'écran 70 qui permet à l'utilisateur de définir graphiquement le projet qu'il veut implanter dans le composant 4.

Pour cela, l'utilisateur sélectionne, en 162 différents blocs fonctionnels prédéfinis paramétrables ou non-paramétrables tels que les blocs 84, 86 et 88.

Ensuite, l'utilisateur définit, en 164, pour chacun des blocs fonctionnels prédéfinis paramétrables la valeur des paramètres en cliquant à l'aide de la souris 74 sur l'élément de commande correspondant et en saisissant à l'aide du clavier 72 la valeur de ce paramètre. En réponse au signal de commande généré lorsqu'un élément de commande est activé, le module 130 enregistre dans la table de description 132 la valeur saisie par le paramètre correspondant.

A titre d'exemple, l'utilisateur sélectionne, en 166, le bloc fonctionnel non-prédéfini 104 et décrit en utilisant le langage de programmation VHDL le fonctionnement de ce bloc.

Finalement, en 170, les relations entre ces différents blocs fonctionnels sont définies par l'utilisateur par de simples opérations de glisser-déposer plus connues sous les termes "drag and drop".

Une fois que l'ensemble du projet a été défini par l'utilisateur, le module 96 procède à une étape 174 d'acquisition du projet défini grâce à l'interface graphique.

Le programme écrit pour définir le fonctionnement du bloc 104 est alors compilé par le module 106 lors d'une étape 176.

Le module d'assemblage 120 sélectionne alors automatiquement, lors d'une étape 178, les portions de codes compilées suivantes :
- le code précompilé 110 correspondant au noyau 50,
- les portions de codes précompilés 98, 99 correspondant uniquement aux blocs fonctionnels prédéfinis sélectionnés dans ce projet, c'est-à-dire ici ceux correspondant aux 84, 86 et 88,
- les portions de codes précompilés 114, 115 correspondant respectivement aux processeurs 51 et 56, et
- le code compilé lors de l'étape 176.

Les codes du noyau 50 et des processeurs 51 et 56 sont, ici, systématiquement sélectionnés.

A la fin de cette étape de sélection, le module 120 assemble, lors d'une étape 180, les différentes portions de codes sélectionnées en tenant compte des relations définies entre celles-ci lors de l'opération 170. A cet effet, le module 120 met en oeuvre un processus connu sous les termes de placement/routage de manière à obtenir le fichier 122 prêt à être téléchargé dans le composant 4. Le module propre à mettre en oeuvre le processus de placement routage est connu sous le terme anglais "fitter". Cette étape est réalisée de façon automatique en tenant compte de règles connues telle que la règle consistant à placer dans le composant 4 les processeurs nécessitant l'accès le plus rapide à une ressource le plus près de cette ressource.

A l'issue de l'étape 180, le module 124 programme, lors d'une étape 181, le composant 4 en téléchargeant par l'intermédiaire du bus 40 le fichier 122 établi par le module d'assemblage 120.

Parallèlement à l'étape 181, le module 130 procède à une étape 182 de construction automatique de la table de description 132 à partir des valeurs des paramètres acquises au fur et à mesure de la définition du projet lors de l'opération 164.

Ensuite, si cela n'a pas déjà été fait au préalable, lors d'une étape 184, le module 134 construit et télécharge les librairies 44 et 46 dans la mémoire 16 en ne retenant parmi les différentes procédures disponibles dans l'interface de programmation 112 que celles nécessaires pour échanger des informations avec les processeurs véritablement implantés lors de l'étape 181 dans le composant 4. Le téléchargement s'effectue, par exemple, de la même façon que pour la programmation d'un microprocesseur classique.

Lorsque ces librairies 44 et 46 sont présentes dans la mémoire 16 du microprocesseur 14, celui-ci peut communiquer d'une part avec l'ordinateur 6 par l'intermédiaire du bus 19 et, d'autre part, avec le processeur 51 du composant 4. Dès lors, le module 134 télécharge, lors d'une étape 186, par l'intermédiaire du bus 19 la table de description 132 dans la mémoire 36 pour remplacer ou mettre à jour, par exemple, la table 64.

Une fois le microprocesseur et le composant 4 programmés, l'utilisateur peut procéder au test de la carte électronique 10.

On remarquera que lors du fonctionnement de la carte 10 la gestion de l'accès à la mémoire 36 est réalisée par le noyau 50 de sorte que le microprocesseur 14 ou l'ordinateur 6 est déchargé de cette tâche. Dès lors, le microprocesseur 14 n'est chargé que d'opérations relativement lentes de sorte que celles-ci peuvent être réalisées à l'aide d'un microprocesseur présentant une faible puissance de traitement.

De plus, ici, les paramètres de fonctionnement des différents processeurs sont enregistrés dans la mémoire réinscriptible 36 externe au composant 4. Ainsi, si le test du fonctionnement de la carte 10 ne s'avère pas satisfaisant, et si la correction ou l'amélioration de ce fonctionnement nécessite uniquement la modification de la valeur d'un paramètre, l'utilisateur modifie dans son projet la valeur de ce paramètre, le module 130 reconstruit une nouvelle table de description qui est alors téléchargée par le module 134 dans la mémoire 36. Cette nouvelle table est transmise par l'intermédiaire du bus 19 au microprocesseur 14 qui la transmet au processeur 51. Le processeur 51 accède alors à la mémoire 36 par l'intermédiaire du noyau 50 pour modifier les valeurs de l'ancienne table. Ainsi, contrairement à de nombreux systèmes connus, il n'est pas nécessaire de reprogrammer le composant FPGA pour modifier la valeur de différents paramètres de fonctionnement. Ceci réduit le temps de développement et de conception de la carte électronique 8.

On remarquera également que l'utilisation de portions de codes précompilés correspondant aux blocs fonctionnels prédéfinis permet d'éviter d'avoir à les compiler ce qui réduit le temps de conception du composant 4.

La puissance de traitement nécessaire pour le microprocesseur 14 étant réduite, il n'est pas nécessaire d'avoir recours à la puissance de traitement de l'ordinateur 6 de sorte que la carte 10 une fois programmée peut fonctionner de façon autonome sans connexion à l'ordinateur 6.

Pour une grande part du projet défini à l'aide de l'atelier 2, l'utilisateur utilise des blocs fonctionnels prédéfinis associés à des portions de code prédéfinies correspondant chacune à des processeurs prédéfinis. Ainsi, l'utilisateur n'a pas à écrire le code correspondant à ces processeurs prédéfinis ce qui accélère considérablement la conception d'un composant FPGA. En particulier, l'utilisateur n'a pas à écrire le code correspondant au noyau 50.

La carte 10 a été décrite ici dans le cas particulier où celle-ci se trouve à l'extérieur de l'ordinateur 6. Toutefois, en variante, cette carte 10 peut être intégrée à l'intérieur de l'ordinateur. Dans ce cas là, par exemple, le bus USB 19 est remplacé par un bus PCI.

D'autres actionneurs et/ou capteurs que ceux décrits ici peuvent être raccordés à la carte 10 par l'intermédiaire d'interfaces appropriées.

## Revendications

1. Atelier de conception d'un réseau prédiffusé programmable (4), cet atelier comportant :
- une interface homme/machine et un module (80) de création et de gestion d'une interface graphique permettant à un utilisateur de définir graphiquement des blocs fonctionnels et des relations entre ces blocs fonctionnels, chaque bloc fonctionnel étant associé à une portion de code respective correspondant chacune à au moins un processeur respectif à implanter dans le réseau prédiffusé programmable, ces différents processeurs à implanter étant destinés à s'exécuter en parallèle dans le réseau prédiffusé programmable, et
- des moyens (100) de stockage d'informations propre à contenir lesdites portions de code,
**caractérisé :**
- **en ce que** les moyens (100) de stockage d'informations comportent une portion de code prédéfinie (110) correspondant à un noyau temps réel câblé, ce noyau temps réel câblé étant apte à synchroniser l'exécution des différents processeurs correspondant aux blocs fonctionnels définis par l'utilisateur lorsqu'il est implanté dans le réseau prédiffusé programmable, et
- **en ce que** l'atelier comporte un module (120) d'assemblage automatique par placement/routage des portions de code associées aux blocs fonctionnels définis par l'utilisateur et de la portion de code correspondant au noyau temps réel câblé de manière à obtenir un fichier (122) prêt à être téléchargé dans le réseau prédiffusé programmable.

2. Atelier selon la revendication 1, **caractérisé en ce que** l'interface homme / machine et le module (80) de création et de gestion de l'interface graphique sont aptes à permettre la sélection par l'utilisateur d'au moins un bloc fonctionnel prédéfini, chaque bloc fonctionnel prédéfini étant associé à une portion de code prédéfinie correspondant à au moins un processeur prédéfini apte à coopérer avec le noyau temps réel câblé lorsqu'il est implanté dans le composant (4).

3. Atelier selon la revendication 2, **caractérisé :**
- **en ce que** l'interface homme / machine et le module (80) de création et de gestion de l'interface graphique sont aptes à permettre la sélection par l'utilisateur d'au moins un bloc fonctionnel prédéfini paramétrable, et la définition par l'utilisateur des valeurs du ou de chaque paramètre du bloc fonctionnel prédéfini paramétrable sélectionné, chaque bloc fonctionnel prédéfini paramétrable étant associé à une portion de code prédéfinie correspondant à au moins un processeur prédéfini paramétrable, chaque processeur paramétrable étant apte à émettre une requête de lecture de la valeur du ou de chaque paramètre nécessaire à son fonctionnement lors de son exécution dans le réseau prédiffusé programmable, et
- **en ce que** la portion de code prédéfinie (10) correspondant au noyau temps réel câblé correspond à un noyau temps réel câblé apte, en réponse auxdites requêtes de lecture, à lire la valeur des paramètres correspondant dans un fichier enregistré dans une mémoire externe réinscriptible (36) associée au réseau prédiffusé programmable, et à transmettre la valeur du ou de chaque paramètre lu au processeur l'ayant demandée.

4. Atelier selon la revendication 3, **caractérisé en ce qu'**il comporte un module de génération (130) apte à produire automatiquement ledit fichier à partir de la définition des blocs fonctionnels sélectionnés par l'utilisateur.

5. Atelier selon l'une quelconque des revendications précédentes, **caractérisé en ce que** l'interface homme / machine et le module (80) de création et de gestion sont aptes à permettre la définition du fonctionnement d'un bloc fonctionnel non-prédéfini par écriture dans un langage de programmation de cette définition et à permettre à l'utilisateur de définir graphiquement des relations entre ce bloc fonctionnel non-prédéfini et d'autres blocs fonctionnels prédéfinis, et **en ce qu'**il comporte un compilateur (106) propre à compiler la définition écrite avec le langage de programmation pour créer un code compilé associé à ce bloc fonctionnel non-prédéfini apte à être assemblé par le module d'assemblage avec la portion de code prédéfinie correspondant au noyau temps réel câblé.

6. Atelier selon l'une quelconque des revendications précédentes, **caractérisé en ce que** les moyens (100) de stockage d'informations contiennent une portion de code prédéfinie correspondant à un processeur prédéfini formant interface d'entrée, ce processeur étant apte, lorsqu'il est implanté dans le réseau prédiffusé programmable, à gérer les échanges d'informations entre un microprocesseur externe (14) associé au réseau prédiffusé programmable (9) et les différents processeurs correspondant aux blocs fonctionnels définis par l'utilisateur, et **en ce que** le module d'assemblage (120) est apte à assembler automatiquement et systématiquement en plus des portions de code associées aux blocs fonctionnels définis par l'utilisateur et au noyau temps réel câblé, la portion de code prédéfinie de ce processeur formant interface d'entrée.

7. Atelier selon la revendication 6, **caractérisé en ce que** les moyens (100) de stockage d'informations comportent une librairie prédéfinie (112) de procédures aptes à être implémentées dans le microprocesseur (14) associé au réseau prédiffusé programmable (4) pour permettre à ce microprocesseur d'échanger des informations entre les différents processeurs implantés dans le réseau prédiffusé programmable par l'intermédiaire du processeur (51) formant interface d'entrée.

8. Atelier selon l'une quelconque des revendications précédentes, **caractérisé en ce que** les moyens (100) de stockage d'informations contiennent une portion de code prédéfinie correspondant à un processeur prédéfini formant interface de sortie, ce processeur étant apte, lorsqu'il est implanté dans le réseau prédiffusé programmable, à gérer les échanges d'informations entre au moins un dispositif électronique commandable (30, 32) raccordé au réseau prédiffusé programmable (4) et au moins l'un des processeurs implantés (51 à 56) dans le réseau prédiffusé programmable, et **en ce que** le module d'assemblage (120) est apte à assembler systématiquement et automatiquement, en plus des portions de code associées aux blocs fonctionnels définis par l'utilisateur et au noyau temps réel câblé, la portion de code prédéfinie de ce processeur (56) formant interface de sortie.

9. Atelier selon la revendication 8, **caractérisé en ce que** la portion de code prédéfinie correspondant au processeur (56) formant interface de sortie, correspond à un processeur formant interface de sortie apte à reconnaître automatiquement le ou chaque dispositif électronique commandable (30, 32) raccordé au réseau prédiffusé programmable pour communiquer avec celui-ci à l'aide d'un protocole approprié.

10. Atelier selon l'une quelconque des revendications précédentes, **caractérisé en ce qu'**il comporte un module (134) de téléchargement du fichier généré par le module d'assemblage dans le réseau prédiffusé programmable.

11. Atelier selon l'une quelconque des revendications précédentes, **caractérisé en ce que** la portion de code correspondant au noyau temps réel câblé et / ou les portions de codes prédéfinies correspondant aux processeurs prédéfinis sont des portions de codes précompilées prêtes à être téléchargées dans le réseau prédiffusé programmable.

12. Procédé de conception d'un réseau prédiffusé programmable formé dans un substrat, ce procédé comportant :
- une étape (160) de création et de gestion automatique d'une interface graphique permettant à un utilisateur de définir graphiquement des blocs fonctionnels et des relations entre ces blocs fonctionnels, chaque bloc fonctionnel étant associé à une portion de code respective correspondant à au moins un processeur à implanter dans le réseau prédiffusé programmable, ces différents processeurs à implanter étant destinés à s'exécuter en parallèle dans le réseau prédiffusé programmable,
**caractérisé en ce qu'**il comporte :
- une étape (180) d'assemblage automatique par placement / routage des différentes portions de code associées aux blocs fonctionnels définis par l'utilisateur et d'une portion de code prédéfinie correspondant à un noyau temps réel câblé de manière à obtenir un fichier (122) prêt à être téléchargé dans le réseau prédiffusé programmable, la portion de code prédéfinie correspondant au noyau temps réel câblé étant apte à synchroniser l'exécution des différents processeurs associés aux blocs fonctionnels définis par l'utilisateur lorsqu'ils sont implantés dans le réseau prédiffusé programmable.

13. Procédé selon la revendication 12, **caractérisé en ce qu'**il comporte une étape de création et de gestion d'une interface graphique permettant la sélection par un utilisateur de blocs fonctionnels prédéfinis associés chacun à une portion de code prédéfinie correspondant à au moins un processeur prédéfini apte à coopérer avec le noyau temps réel câblé (50) lorsqu'il est implanté dans le réseau prédiffusé programmable.

14. Support d'enregistrement d'informations, **caractérisé en ce qu'**il comporte des instructions pour l'exécution du procédé conforme à l'une quelconque des revendications 12 à 13, et à la mise en oeuvre de l'atelier selon l'un des revendications 1 à 11 lorsque ces instructions sont exécutées par un calculateur électronique (6).
